# EUROPÄISCHE PATENTSCHRIFT

(11) **EP 3 563 649 B1**
(45) Veröffentlichungstag und Bekanntmachung des Hinweises auf die Patenterteilung: **08.05.2024**
(21) Anmeldenummer: 18729062.2
(22) Anmeldetag: 24.05.2018
(51) Int. Cl.: H05K 7/12, H05K 3/30

(54) **BAUTEILHALTEVORRICHTUNG**
COMPONENT HOLDING DEVICE
DISPOSITIF DE FIXATION DE COMPOSANT

(30) Priorität: 01.06.2017 DE 102017112037
(43) Veröffentlichungstag der Anmeldung: 06.11.2019
(73) Patentinhaber: ebm-papst Mulfingen GmbH & Co. KG, 74673 Mulfingen (DE)
(72) Erfinder: BERBERICH, Joachim, 74722 Buchen (DE); FRÖHLICH, Jan, 97941 Hochhausen (DE); LUST, Alexander, 74182 Obersulm (DE)
(74) Vertreter: Staeger & Sperling Partnerschaftsgesellschaft mbB
(86) Internationale Anmeldenummer: PCT/EP2018/063631
(87) Internationale Veröffentlichungsnummer: WO 2018/219769

(56) Entgegenhaltungen:
- DE-A1- 3 609 424
- DE-A1-102009 011 993
- DE-A1-102010 028 164
- US-A- 5 117 330

## Beschreibung

Die Erfindung betrifft eine Bauteilhaltevorrichtung zur positionsfesten Anordnung eines elektrischen Bauteils an einer Leiterplatte mit Toleranzausgleich.

Herkömmlicherweise werden elektrische Bauteile an Leiterplatten angeordnet und verlötet, ohne dass ein Ausgleich von Fertigungstoleranzen zwischen dem elektrischen Bauteil und der Leiterplatte sowie zwischen dem elektrischen Bauteil und einem angrenzenden Elektronikgehäuse erfolgt. Damit ist jedoch keine definierte Abstandslage des elektrischen Bauteils auf einer Leiterplatte gegenüber dem Elektronikgehäuse sichergestellt. Deshalb werden die elektronischen Bauteile häufig an dem Elektronikgehäuse selbst befestigt.

Zwischen der Leiterplatte und dem anzulötenden elektrischen Bauteil wurden zudem Abstandshalter, beispielsweise Dioden eingesetzt, um eine definierte Abstandslage des elektrischen Bauteils gegenüber der Leiterplatte beim Verlöten zu gewährleisten. Dabei ist nachteilig, dass während des Lötvorgangs die Lötmaske das elektrische Bauteil durch einen Niederhalter festgelegt muss. Zudem erfolgt die Fixierung des elektrischen Bauteils an der Leiterplatte meist durch Schrauben, die sich durch das elektrische Bauteil bis zur Leiterplatte (oder darüber hinaus) erstrecken und beim Festziehen unmittelbar auf das elektrische Bauteil einwirken. Dies kann zu Beschädigungen oder gar zum Bruch führen.

Stand der Technik zu Bauteilhaltevorrichtungen in anderen technischen Gebieten ist in den Dokumenten DE 10 2009 011 993 A1, DE 36 09 424 A1, US 5,117,330 A und DE 10 2010 028 164 A1 offenbart.

Der Erfindung liegt deshalb die Aufgabe zugrunde, eine Bauteilhaltevorrichtung bereit zu stellen, die einen Toleranzausgleich eines auf eine Leiterplatte zu befestigenden elektrischen Bauteils gegenüber angrenzenden Bauteilen, wie einem Elektronikgehäuse, sowie eine definierte jeweilige positionsfeste Abstandslage zueinander ermöglicht.

Diese Aufgabe wird durch die Merkmalskombination gemäß Patentanspruch 1 gelöst.

Erfindungsgemäß wird eine Bauteilhaltevorrichtung ausgebildet zur positionsfesten Anordnung eines elektrischen Bauteils an einer Leiterplatte mit einer Auflageseite zur Aufnahme des elektrischen Bauteils vorgeschlagen. Auf der Auflageseite sind mindestens ein Vorspannelement und zumindest ein erstes Rastelement zur positionsfesten Verrastung des elektrischen Bauteils vorgesehen, wobei das mindestens eine Vorspannelement ausgebildet ist, auf das elektrische Bauteil eine Vorspannkraft auszuüben, welche das elektrische Bauteil gegen das mindestens eine erste Rastelement drückt. Die Bauteilhaltevorrichtung umfasst ferner mindestens ein zweites Rastelement auf einer der Auflageseite gegenüberliegenden Unterseite, wobei das zweite Rastelement ausgebildet ist, die Bauteilhaltevorrichtung in einer vordefinierten Lage positionsfest an der Leiterplatte zu fixieren, wobei das Vorspannelement ein elastisch federnder Vorspannbügel ist, der ausgebildet ist, eine flächige Vorspannkraft auf das elektrische Bauteil auszuüben, wobei der Vorspannbügel auf der Auflageseite der Bauteilhaltevorrichtung ausgebildet ist und sich zwischen zwei gegenüberliegenden Außenrandabschnitten der Bauteilhaltevorrichtung erstreckt, wobei der Vorspannbügel gegenüber der Auflageseite hervorsteht und eine Anlagefläche an dem elektrischen Bauteil bildet wenn dieses an die Bauteilhaltevorrichtung aufgesetzt ist, so dass nach dem Einrasten des ersten Rastelements die Vorspannkraft das elektrische Bauteil in einem positionsfesten Abstand zu der Bauteilhaltevorrichtung hält.

Über das erste Rastelement erfolgt eine arretierte Befestigung des elektrischen Bauteils in einer vorbestimmten Position und Abstandslage auf der Auflageseite der Bauteilhaltevorrichtung, wobei das Vorspannelement das elektrische Bauteil permanent gegen das erste Rastelement drückt. Zusätzlich ermöglicht das zweite Rastelement auf der zur Auflageseite gegenüberliegenden Unterseite eine Fixierung der Bauteilhaltevorrichtung an der Leiterplatte in einer ebenfalls vordefinierten und festgelegten Abstandslage. Über die doppelte, zweiseitige Abstandsfestlegung erfolgt der Toleranzausgleich. Im verrasteten Zustand bildet die Bauteilhaltevorrichtung mit dem elektrischen Bauteil eine Einheit, so dass die elektrischen Anschlüsse des elektrischen Bauteils ohne zusätzliche Hilfsmittel verlötet werden können. Zudem kann eine derartige Einheit aus elektrischem Bauteil und Bauteilhaltevorrichtung in die Leiterplatte eingedrückt und mittels der zweiten Rastelemente positionsfest fixierend festgelegt werden.

In einer Ausführung der Bauteilhaltevorrichtung ist vorgesehen, dass das erste und zweite Rastelement lösbar an dem elektrischen Bauteil bzw. der Leiterplatte verrastbar sind.

Für eine derartige Lösung ist das erste Rastelement in einem Ausführungsbeispiel als Rasthaken mit einem einen Anschlag bildenden Hintergriffabschnitt zur positionsfesten Verrastung in dem elektrischen Bauteil ausgebildet. Das zweite Rastelement ist ebenfalls als Rasthaken mit einem einen Anschlag bildenden Hintergriffabschnitt zur positionsfesten Verrastung in der Leiterplatte ausgebildet.

Die Rasthaken können mit schrägen Einführflächen versehen sein, so dass sie in entsprechende Öffnungen an dem elektrischen Bauteil bzw. der Leiterplatte einführbar sind und nach Überfahren des jeweiligen Hinterschnitts elastisch einschnappen. In einer Variante sind an den Rasthaken mehrere nacheinander zu überfahrende Hinterschnitte vorgesehen, welche unterschiedliche Verrastpositionen und somit unterschiedliche Höhen- bzw. Abstandslagen bestimmen.

Als Vorspannelement wird bei der Bauteilhaltevorrichtung erfindungsgemäß ein elastisch federnder Vorspannbügel eingesetzt, der eine flächige Vorspannkraft auf das elektrische Bauteil ausüben kann. Der Vorspannbügel steht gegenüber der Auflageseite hervor und bildet eine Anlagefläche an dem elektrischen Bauteil, wenn dieses an die Bauteilhaltevorrichtung aufgesetzt wird. Dabei drückt der elastische Vorspannbügel mit seiner Vorspannkraft flächig gegen das elektrische Bauteil. Nach dem Einrasten des ersten Rastelements hält die Vorspannkraft das elektrische Bauteil in einem positionsfesten Abstand zu der Bauteilhaltevorrichtung,

In einer Ausführungsvariante ist vorgesehen, dass das erste Rastelement eine Sollbruchstelle zum positionsdefinierten Abtrennen von der Bauteilhaltevorrichtung aufweist. Die Sollbruchstelle ermöglicht, das erste Rastelement nach dem Verlöten des elektrischen Bauteils an der Leiterplatte zu entfernen. Die Fixierung wird nach dem verlöten nicht weiter benötigt. Zudem kann gewährleistet werden, dass keine Elemente des Rastelements über das elektrische Bauteil hervorstehen. Das elektrische Bauteil kann somit näher an einer Kühleinrichtung (z.B. Kühlrippen, Luftschlitze) des Elektrogehäuses positioniert und mithin die Kühlleistung verbessert werden.

In einer vorteilhaften Ausführung der Bauteilhaltevorrichtung ist in einem an einen Außenrand der Bauteilhaltevorrichtung anschließenden Außenrandabschnitt mindestens ein sich von der Auflageseite zu der Unterseite erstreckendes Durchgangsloch vorgesehen, durch welches ein Befestigungsmittel, beispielsweise eine Schraube, zum Befestigen der Bauteilhaltevorrichtung an der Leiterplatte hindurchführbar ist, ohne sich durch das elektrische Bauteil zu erstrecken. Als Variante hat das elektrische Bauteil im Bereich des Durchgangsloches eine Aussparung. Die Befestigung erfolgt somit nicht mehr mit einer Krafteinwirkung der Schraube auf das elektrische Bauteil, sondern unmittelbar auf die Bauteilhaltevorrichtung. Beschädigungen am elektrischen Bauteil oder gar ein Bruch können verhindert werden.

In einer Weiterbildung der Bauteilhaltevorrichtung ist vorgesehen, dass erste Rastelemente auf zumindest zwei gegenüberliegenden Außenseiten der Bauteilhaltevorrichtung vorgesehen sind, die jeweils einen von der Auflageseite vorstehenden Haltebügel aufweisen. Über die Haltebügel kann die Bauteilhaltevorrichtung leichter in die Leiterplatte eingesetzt werden, ohne dass das elektrische Bauteil berührt werden muss. Zudem bieten die Haltebügel einen Angriffspunkt zum Einleiten einer Kraft zum Abtrennen der ersten Rastelemente an der jeweiligen Sollbruchstelle von der Bauteilhaltevorrichtung.

Auch ist eine Ausführung vorteilhaft, bei der zweite Rastelemente auf zumindest zwei gegenüberliegenden Außenseiten der Bauteilhaltevorrichtung vorgesehen sind, um zumindest zwei Befestigungspunkte zwischen der Bauteilhaltevorrichtung und der Leiterplatte zu erzeugen. Die jeweils mindestens zwei Rastelemente auf gegenüberliegenden Außenseiten ermöglichen ein paralleles Aufsetzen und Fixieren des elektrischen Bauteils auf die Bauteilhaltevorrichtung sowie der Einheit aus elektrischem Bauteil und Bauteilhaltevorrichtung auf die Leiterplatte.

In einem Ausführungsbeispiel der Bauteilhaltevorrichtung ist auf der Auflageseite mindestens ein Führungssteg vorgesehen, der eine Führung beim Einsetzen des elektrischen Bauteils an die Bauteilhaltevorrichtung gewährleistet. Insbesondere ist vorteilhaft, wenn auf zumindest zwei gegenüberliegenden Außenseiten der Auflageseite jeweils mindestens ein Führungssteg vorgesehen ist, zwischen die das elektrische Bauteil an die Bauteilhaltevorrichtung einsetzbar ist. Die Führungsstege erleichtern die korrekte Positionierung des elektrischen Bauteils auf der Bauteilhaltevorrichtung, da es von den Führungsstegen geführt auf die Bauteilhaltevorrichtung aufsetzbar ist, bis die ersten Rastelemente in die Bauteilhaltevorrichtung eingreifen.

In einer weiter günstigen Ausführung ist die Bauteilhaltevorrichtung einstückig ausgebildet und beispielsweise im Spritzguss gefertigt.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: eine perspektivische Ansicht einer erfindungsgemäßen Bauteilhaltevorrichtung;
- Fig. 2: eine perspektivische Ansicht der Bauteilhaltevorrichtung aus Figur 1 mit darauf befestigtem elektrischem Bauteil;
- Fig. 3: eine perspektivische Ansicht der auf einer Leiterplatte fixierten Bauteilhaltevorrichtung aus Figur 2;
- Fig. 4: eine Seitenansicht des Ausführungsbeispiels gemäß Figur 3.

Gleiche Bezugszeichen benennen in den Figuren gleiche Teile.

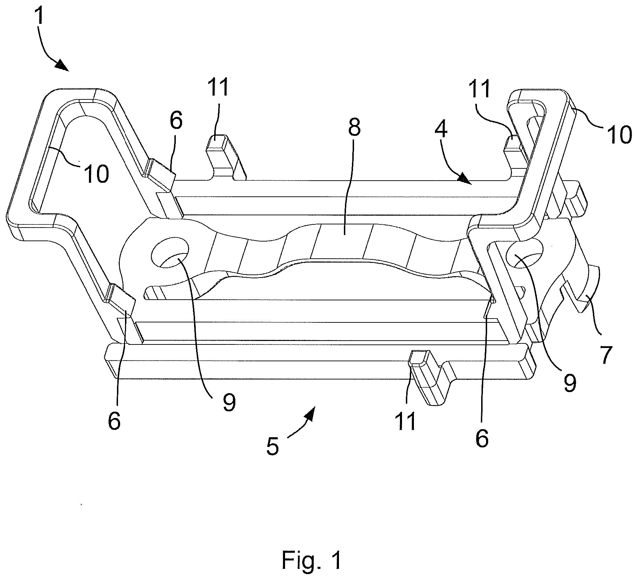

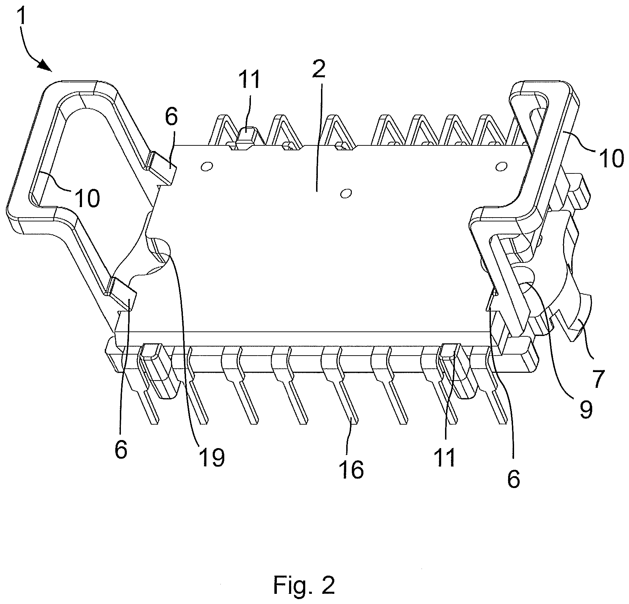

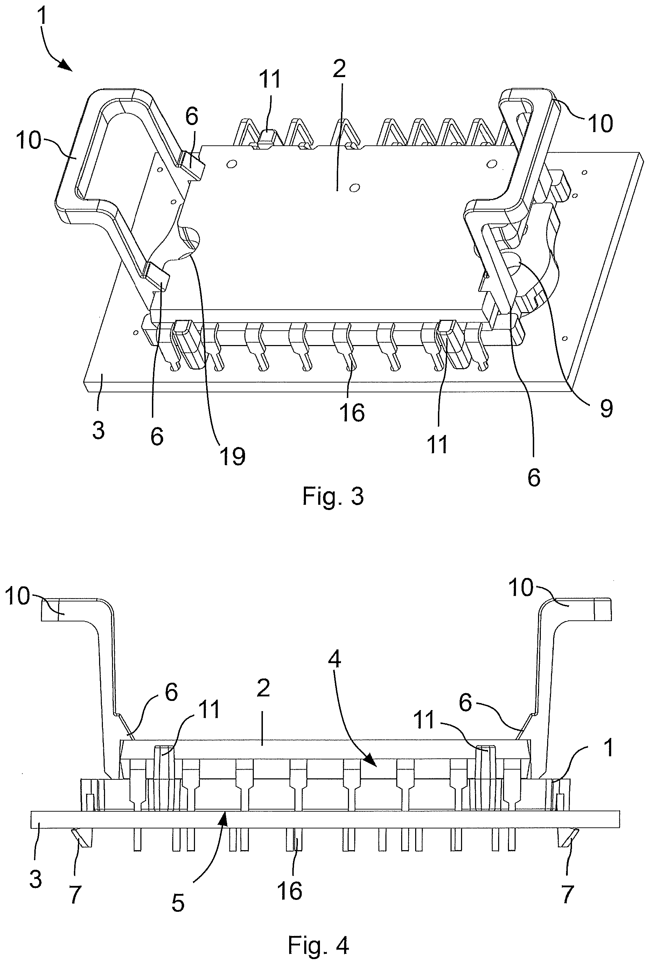

In Figur 1 ist eine perspektivische Ansicht einer erfindungsgemäßen einstückigen Bauteilhaltevorrichtung 1 gezeigt. Die Bauteilhaltevorrichtung 1 dient zur positionsfesten Anordnung eines elektrischen Bauteils 2 (beispielhaft ist ein Leistungsmodul dargestellt) an einer Leiterplatte 3, wie es die Figuren 3 und 4 offenbaren. Das elektrische Bauteil 2 wird an der Bauteilhaltevorrichtung 1 fixiert, wie in Figur 2 gezeigt.

Bezugnehmend auf die Figuren 1 - 4 umfasst die Bauteilhaltevorrichtung 1 eine obere Auflageseite 4 mit einer Auflagefläche zur Aufnahme des elektrischen Bauteils 2. Auf der Auflageseite 4 der Bauteilhaltevorrichtung 1 ist ein elastisch federnder Vorspannbügel 8 ausgebildet, der sich zwischen zwei gegenüberliegenden Außenrandabschnitten der Bauteilhaltevorrichtung 1 erstreckt und von der Auflagefläche vorsteht, um eine flächige Vorspannkraft auf das elektrische Bauteil 2 auszuüben. Die Bauteilhaltevorrichtung 1 umfasst ferner vier Rasthaken 6 zur positionsfesten Verrastung des elektrischen Bauteils 2 an der Bauteilhaltevorrichtung 1. Die vier Rasthaken 6 sind jeweils mit einem einen Anschlag bildenden Hintergriffabschnitt zur positionsfesten Verrastung in dem elektrischen Bauteil 2 ausgebildet, wie in den Figuren 2 - 4 gezeigt, wobei die Rasthaken 6 nach innen weisen, um das elektrische Bauteil 2 an seinem Außenrand zu umgreifen. Im eingesetzten Zustand drückt der Vorspannbügel 8 das elektrische Bauteil 2 permanent gegen die Anschläge der Rasthaken 6. Das elektrische Bauteil 2 ist somit positionsfest gegenüber der Bauteilhaltevorrichtung 1 fixiert. Jeweils zwei Rasthaken 6 sind durch auf zwei gegenüberliegenden Außenseiten der Bauteilhaltevorrichtung 1 gebildete Haltebügel 10 verbunden. Über die Haltebügel 10 ist die Bauteilhaltevorrichtung 1 mit dem darauf befestigen elektrischen Bauteil 2 gut handhabbar und auf der Leiterplatte 3 positionierbar. Zudem bieten die verlängert vorstehenden Haltebügel 10 einen Hebel, durch den die Rasthaken 6 nach Fixierung des elektrischen Bauteils 2 auf der Bauteilhaltevorrichtung 1 bzw. der Leiterplatte 3 weggebrochen werden können. Im Bereich der Rasthaken 6 kann hierfür (nicht gezeigt) zudem eine Solbruchstelle vorgesehen werden.

Die Bauteilhaltevorrichtung 1 umfasst auf der der Auflageseite 4 gegenüberliegenden Unterseite 5 zwei in den Außenrandabschnitten ausgebildete Rasthaken 7, über die die Bauteilhaltevorrichtung 1 in vordefinierter Lage positionsfest an der Leiterplatte 3 fixiert wird. Auch die Rasthaken 7 weisen jeweils einen einen Anschlag bildenden Hintergriffabschnitt auf, mittels dem die Bauteilhaltevorrichtung 1 positionsfest in entsprechenden Öffnungen in der Leiterplatte 3 verrastet wird, wie in den Figuren 3 und 4 gezeigt. Die Hintergriffabschnitte der Rasthaken 7 sind mit einer Schräge ausgebildet, um die Toleranz der Leiterplatte 3 auszugleichen.

In den sich an den Außenrand der Bauteilhaltevorrichtung 1 anschließenden Außenrandabschnitten sind zwei sich jeweils von der Auflageseite 4 zur Unterseite 5 erstreckende Durchgangslöcher 9 vorgesehen, durch die eine Schraube oder ein anderes geeignetes Befestigungsmittel durchführbar ist, um die Bauteilhaltevorrichtung 1 an der Leiterplatte 3 oder einem anderen nicht dargestellten Bauteil unterhalb der Leiterplatte 3 zu befestigen. Das elektrische Bauteil 2 weist im Bereich der Durchgangslöcher 9 Aussparungen 19 auf, so dass die Befestigung der Bauteilhaltevorrichtung 1 unabhängig von dem elektrischen Bauteil 2 erfolgen kann. Durch diese Lösung ist zudem die Anschraubfläche auf der Bauteilhaltevorrichtung 1 vergrößerbar.

An seinem Außenrand weist die Bauteilhaltevorrichtung 1 an zwei gegenüberliegenden Außenseiten jeweils zwei Führungsstege 11 auf, die das elektrischen Bauteil 2 beim Einsetzen an die Bauteilhaltevorrichtung 1 führen und im eingebauten Zustand eine seitliche Abstützung gewährleisten, wie in den Figuren 3 und 4 dargestellt.

Zur Montage wird zunächst das elektrische Bauteil 2 gegen die Vorspannkraft des Vorspannbügels 8 der Bauteilhaltevorrichtung 1 gedrückt, bis die Rasthaken 6 das elektrische Bauteil 2 hintergreifen. Die in Figur 2 gezeigte Einheit aus Bauteilhaltevorrichtung 1 und elektrischem Bauteil 2 hat dann einen vordefinierten und festgelegten Abstand. In diesem Zustand wird die Einheit aus Bauteilhaltevorrichtung 1 und elektrischem Bauteil 2 auf die Leiterplatte 3 aufgesetzt, so dass die Rasthaken 7 die Leiterplatte 3 hintergreifen, wie in den Figuren 3 und 4 gezeigt. Dann können die Anschlüsse 16 des elektrischen Bauteils 2 an der Leiterplatte 3 ohne zusätzliche Hilfsmittel auf Position gehalten und verlötet werden. Schließlich können die Haltebügel 10 mit den Rasthaken 6 weggebrochen werden, so dass die Oberfläche des elektrischen Bauteils 2 die oberste Fläche freie Fläche bildet und näher an Kühleinrichtungen in einem Elektrogehäuse platzierbar ist.

## Patentansprüche

1. Bauteilhaltevorrichtung (1) ausgebildet zur positionsfesten Anordnung eines elektrischen Bauteils (2) an einer Leiterplatte (3),
mit einer Auflageseite (4) zur Aufnahme des elektrischen Bauteils (2), wobei auf der Auflageseite (4) mindestens ein Vorspannelement und zumindest ein erstes Rastelement zur positionsfesten Verrastung des elektrischen Bauteils (2) vorgesehen sind und das mindestens eine Vorspannelement ausgebildet ist, auf das elektrische Bauteil (2) eine Vorspannkraft auszuüben, welche das elektrische Bauteil (2) gegen das mindestens eine erste Rastelement drückt,
und mit mindestens einem zweiten Rastelement auf einer der Auflageseite (4) gegenüberliegenden Unterseite (5), wobei das zweite Rastelement ausgebildet ist, die Bauteilhaltevorrichtung (1) in einer vordefinierten Lage positionsfest an der Leiterplatte (3) zu fixieren, **dadurch gekennzeichnet, dass** das Vorspannelement ein elastisch federnder Vorspannbügel (8) ist, der ausgebildet ist, eine flächige Vorspannkraft auf das elektrische Bauteil (2) auszuüben, wobei der Vorspannbügel (8) auf der Auflageseite (4) der Bauteilhaltevorrichtung (1) ausgebildet ist und sich zwischen zwei gegenüberliegenden Außenrandabschnitten der Bauteilhaltevorrichtung (1) erstreckt, wobei der Vorspannbügel gegenüber der Auflageseite hervorsteht und eine Anlagefläche an dem elektrischen Bauteil bildet wenn dieses an die Bauteilhaltevorrichtung aufgesetzt ist, so dass nach dem Einrasten des ersten Rastelements die Vorspannkraft das elektrische Bauteil in einem positionsfesten Abstand zu der Bauteilhaltevorrichtung (1) hält.

2. Bauteilhaltevorrichtung nach Anspruch 1, **dadurch gekennzeichnet, dass** das erste und zweite Rastelement lösbar an dem elektrischen Bauteil (2) bzw. der Leiterplatte (3) verrastbar sind.

3. Bauteilhaltevorrichtung nach Anspruch 1 oder 2, **dadurch gekennzeichnet, dass** das erste Rastelement als Rasthaken (6) mit einem einen Anschlag bildenden Hintergriffabschnitt zur positionsfesten Verrastung in dem elektrischen Bauteil (2) ausgebildet ist.

4. Bauteilhaltevorrichtung nach einem der Ansprüche 1 bis 3, **dadurch gekennzeichnet, dass** das zweite Rastelement als Rasthaken (7) mit einem einen Anschlag bildenden Hintergriffabschnitt zur positionsfesten Verrastung in der Leiterplatte (3) ausgebildet ist.

5. Bauteilhaltevorrichtung nach dem vorigen Anspruch, **dadurch gekennzeichnet, dass** der Hintergriffabschnitt des Rasthakens (7) einen schrägen Verlauf aufweist.

6. Bauteilhaltevorrichtung nach einem der vorigen Ansprüche, **dadurch gekennzeichnet, dass** sie einstückig ausgebildet ist.

7. Bauteilhaltevorrichtung nach einem der vorigen Ansprüche, **dadurch gekennzeichnet, dass** das erste Rastelement eine Sollbruchstelle zum positionsdefinierten Abtrennen von der Bauteilhaltevorrichtung (1) aufweist.

8. Bauteilhaltevorrichtung nach einem der vorigen Ansprüche, **dadurch gekennzeichnet, dass** in dem an einen Außenrand der Bauteilhaltevorrichtung (1) anschließenden Außenrandabschnitt mindestens ein sich von der Auflageseite zu der Unterseite (5) erstreckendes Durchgangsloch (9) vorgesehen ist, durch welches ein Befestigungsmittel zum Befestigen der Bauteilhaltevorrichtung (1) an der Leiterplatte (3) hindurchführbar ist, ohne sich durch das elektrische Bauteil (2) zu erstrecken.

9. Bauteilhaltevorrichtung nach einem der vorigen Ansprüche, **dadurch gekennzeichnet, dass** erste Rastelemente auf zumindest zwei gegenüberliegenden Außenseiten der Bauteilhaltevorrichtung vorgesehen sind, die jeweils einen von der Auflageseite (4) vorstehenden Haltebügel (10) aufweisen.

10. Bauteilhaltevorrichtung nach einem der vorigen Ansprüche, **dadurch gekennzeichnet, dass** zweite Rastelemente auf zumindest zwei gegenüberliegenden Außenseiten der Bauteilhaltevorrichtung (1) vorgesehen sind.

11. Bauteilhaltevorrichtung nach einem der vorigen Ansprüche, **dadurch gekennzeichnet, dass** auf der Auflageseite (4) mindestens ein Führungssteg (11) vorgesehen ist, welcher ausgebildet ist, eine Führung beim Einsetzen des elektrischen Bauteils (2) an die Bauteilhaltevorrichtung (1) zu gewährleisten.

12. Bauteilhaltevorrichtung nach dem vorigen Anspruch, **dadurch gekennzeichnet, dass** auf zumindest zwei gegenüberliegenden Außenseiten der Auflageseite (4) jeweils mindestens ein Führungssteg (11) vorgesehen ist, zwischen die das elektrische Bauteil (2) an die Bauteilhaltevorrichtung (1) einsetzbar ist.

13. Bauteilhaltevorrichtung nach einem der vorigen Ansprüche 8 bis 12, **dadurch gekennzeichnet, dass** sie in einem an das mindestens eine Durchgangsloch (9) angrenzenden Bereich eine lokal vergrößerte Auflagefläche für das Befestigungsmittel zum Befestigen der Bauteilhaltevorrichtung (1) an der Leiterplatte (3) aufweist.

## Claims

1. A component holding device (1) formed for the fixed-position arrangement of an electric component (2) on a circuit board (3),
having a support side (4) for receiving the electric component (2), wherein at least one pretensioning element and at least one first latching element for the fixed-position latching of the electric component (2) are provided on the support side (4), and the at least one pretensioning element is designed to exert a pretensioning force on the electric component (2), which presses the electric component (2) against the at least one first latching element,
and having at least one second latching element on an underside (5) lying opposite the support side (4), wherein the second latching element is designed to fix the component holding device (1) in a predefined location in a fixed position on the circuit board (3),
**characterized in that** the pretensioning element is a resiliently springy pretensioning bracket (8) which is designed to exert a planar pretensioning force on the electric component (2), wherein the springy pretensioning bracket (8) is formed on the support side (4) of the component holding device (1) and extends between two opposite outer marginal sections of the component holding device (1), wherein the pretensioning bracket protrudes with respect to the support side and forms a contact surface on the electric component, when said electric component is placed on the component holding device, such that after the latching of the first latching element, the pretensioning force holds the electric component in a fixed-position spacing with respect to the component holding device (1).

2. The component holding device according to Claim 1, **characterized in that** the first and second latching elements can be detachably latched on the electric component (2) or the circuit board (3), respectively.

3. The component holding device according to Claim 1 or 2, **characterized in that** the first latching element is designed as a latching hook (6) with a rear grip section forming an abutment for the fixed-position latching in the electric component (2).

4. The component holding device according to any one of the claims 1 to 3, **characterized in that** the second latching element is designed as a latching hook (7) with a rear grip section forming an abutment for the fixed-position latching in the circuit board (3).

5. The component holding device according to the preceding claim, **characterized in that** the rear grip section of the latching hook (7) has a slanted course.

6. The component holding device according to any one of the preceding claims, **characterized in that** it is designed to form a single piece.

7. The component holding device according to any one of the preceding claims, **characterized in that** the first latching element comprises a predetermined breaking point for the defined-position detachment from the component holding device (1).

8. The component holding device according to any one of the preceding claims, **characterized in that**, in the outer marginal section adjoining an outer margin of the component holding device (1), a through-hole (9) extending from the support side to the underside (5) is provided, through which a fastening means for fastening the component holding device (1) on the circuit board (3) can be led, without extending through the electric component (2).

9. The component holding device according to any one of the preceding claims, **characterized in that** first latching elements are provided on at least two opposite outer sides of the component holding device, which each comprise a holding bracket (10) protruding from the support side (4).

10. The component holding device according to any one of the preceding claims, **characterized in that** second latching elements are provided on at least two opposite outer sides of the component holding device (1).

11. The component holding device according to any one of the preceding claims, **characterized in that**, on the support side (4), at least one guide bar (11) is provided, which is designed to ensure a guiding during insertion of the electric component (2) on the component holding device (1).

12. The component holding device according to the preceding claim, **characterized in that**, on at least two opposite outer sides of the support side (4), in each case at least one guide bar (11) is provided, between which the electric component (2) can be inserted on the component holding device (1).

13. The component holding device according to any one of the preceding Claims 8 to 12, **characterized in that**, in a region adjoining the at least one through-hole (9), it comprises a locally enlarged contact surface for the fastening means for fastening the component holding device (1) on the circuit board (3).

## Revendications

1. Dispositif de fixation de composant (1) conçu pour l'agencement dans une position fixe d'un composant électrique (2) sur une carte de circuit imprimé (3),
comportant un côté support (4) pour recevoir le composant électrique (2), dans lequel au moins un élément de précontrainte et au moins un premier élément d'encliquetage sont prévus sur le côté support (4) pour encliqueter le composant électrique (2) dans une position fixe et l'au moins un élément de précontrainte est conçu pour exercer une force de précontrainte sur le composant électrique (2), qui presse le composant électrique (2) contre l'au moins un premier élément d'encliquetage,
et comportant au moins un second élément d'encliquetage sur une face inférieure (5) opposée au côté support (4), dans lequel le second élément d'encliquetage est conçu pour fixer dans une position fixe le dispositif de fixation de composant (1) dans une position prédéfinie sur la carte de circuit imprimé (3), **caractérisé en ce que** l'élément de précontrainte est un étrier de précontrainte (8) à effet ressort élastique, qui est conçu pour exercer une force de précontrainte surfacique sur le composant électrique (2), dans lequel l'étrier de précontrainte (8) est conçu sur le côté support (4) du dispositif de fixation de composant (1) et s'étend entre deux sections de bord extérieur opposées du dispositif de fixation de composant (1), dans lequel l'étrier de précontrainte dépasse du côté support et forme une surface de contact sur le composant électrique lorsqu'il est posé sur le dispositif de fixation de composant, de sorte, qu'après l'encliquetage du premier élément d'encliquetage, la force de précontrainte maintient le composant électrique à une distance de position fixe par rapport au dispositif de fixation de composant (1).

2. Dispositif de fixation de composant selon la revendication 1, **caractérisé en ce que** les premier et second éléments d'encliquetage peuvent être encliquetés de manière amovible sur le composant électrique (2) ou sur la carte de circuit imprimé (3).

3. Dispositif de fixation de composant selon la revendication 1 ou 2, **caractérisé en ce que** le premier élément d'encliquetage est réalisé sous la forme d'un crochet d'encliquetage (6) comportant une zone de préhension arrière formant une butée pour un encliquetage dans une position fixe dans le composant électrique (2).

4. Dispositif de fixation de composant selon l'une des revendications 1 à 3, **caractérisé en ce que** le second élément d'encliquetage est réalisé sous la forme d'un crochet d'encliquetage (7) comportant une zone de préhension arrière formant une butée pour un encliquetage dans une position fixe dans la carte de circuit imprimé (3).

5. Dispositif de fixation de composant selon la revendication précédente, **caractérisé en ce que** la zone de préhension arrière du crochet d'encliquetage (7) présente un tracé oblique.

6. Dispositif de fixation de composant selon l'une des revendications précédentes, **caractérisé en ce qu'**il est formé d'une seule pièce.

7. Dispositif de fixation de composant selon l'une des revendications précédentes, **caractérisé en ce que** le premier élément d'encliquetage présente un point de rupture théorique pour une séparation dans une position définie du dispositif de fixation de composant (1).

8. Dispositif de fixation de composant selon l'une des revendications précédentes, **caractérisé en ce que** dans la section de bord extérieur adjacente à un bord extérieur du dispositif de fixation de composant (1), au moins un trou traversant (9) s'étendant du côté support jusqu'à la face inférieure (5) est prévu, à travers lequel trou un moyen de fixation pour fixer le dispositif de fixation de composant (1) à la carte de circuit imprimé (3) peut être passé sans s'étendre à travers le composant électrique (2).

9. Dispositif de fixation de composant selon l'une des revendications précédentes, **caractérisé en ce que** des premiers éléments d'encliquetage sont prévus sur au moins deux côtés extérieurs opposés du dispositif de fixation de composant, lesquels éléments présentent chacun un étrier de fixation (10) dépassant du côté support (4).

10. Dispositif de fixation de composant selon l'une des revendications précédentes, **caractérisé en ce que** des seconds éléments d'encliquetage sont prévus sur au moins deux côtés extérieurs opposés du dispositif de fixation de composant (1).

11. Dispositif de fixation de composant selon l'une des revendications précédentes, **caractérisé en ce qu'**au moins une barrette de guidage (11) est prévue sur le côté support (4), laquelle barrette est conçue pour assurer le guidage lors de l'insertion du composant électrique (2) sur le dispositif de fixation de composant (1).

12. Dispositif de fixation de composant selon la revendication précédente, **caractérisé en ce qu'**au moins une barrette de guidage (11) est prévue respectivement sur au moins deux côtés extérieurs opposés du côté support (4), entre lesquelles barettes le composant électrique (2) peut être inséré sur le dispositif de fixation de composant (1).

13. Dispositif de fixation de composant selon l'une des revendications précédentes 8 à 12, **caractérisé en ce qu'**il présente, dans une zone adjacente à l'au moins un trou traversant (9), une surface d'appui localement élargie pour le moyen de fixation destiné à fixer le dispositif de fixation de composant (1) à la carte de circuit imprimé (3).
